# FASCICULE DE BREVET EUROPEEN

(11) **EP 3 788 852 B1**
(45) Date de publication et mention de la délivrance du brevet: **09.03.2022**
(21) Numéro de dépôt: 19719896.3
(22) Date de dépôt: 02.05.2019
(51) Int. Cl.: H05K 7/14

(54) **PROCÉDÉ DE VERROUILLAGE / DÉVERROUILLAGE D'UN MODULE AMOVIBLE ET ENSEMBLE DE MISE EN OEUVRE**
VERFAHREN ZUM VERRIEGELN/ENTRIEGELN EINES ABNEHMBAREN MODULS UND ANORDNUNG ZUR IMPLEMENTIERUNG
METHOD FOR LOCKING/UNLOCKING A REMOVABLE MODULE, AND ASSEMBLY FOR IMPLEMENTATION

(30) Priorité: 03.05.2018 FR 1853843
(43) Date de publication de la demande: 10.03.2021
(73) Titulaire: LATELEC, 31670 Occitanie Labege (FR)
(72) Inventeur: BOUSQUET, Jean François, 31150 BRUGIERES OCCITANIE (FR); PUERTOLAS, Bastien, 31280 AIGREFEUILLE OCCITANIE (FR)
(74) Mandataire: Junca, Eric
(86) Numéro de dépôt international: PCT/EP2019/061175
(87) Numéro de publication internationale: WO 2019/211346

(56) Documents cités:
- EP-A1- 1 331 712
- US-A- 5 010 426
- US-B2- 6 797 879

## Description

### DOMAINE TECHNIQUE

L'invention se rapporte à un procédé de verrouillage /déverrouillage d'un module amovible, en particulier de module électronique, dans une platine d'accueil, ainsi qu'à un ensemble de verrouillage / déverrouillage formé d'un ou plusieurs modules amovibles, d'une platine d'accueil et d'un système de verrouillage/déverrouillage de mise en œuvre d'un tel procédé.

L'invention concerne plus particulièrement le domaine aéronautique où de nombreux modules (nommées également LRU, acronyme de « line replaceable unit » en terminologie anglaise) sont encastrés de manière réversible dans une platine d'accueil avionique appelée baie, meuble ou cabinet. Les modules amovibles sont agencés dans ces logements de manière à pouvoir résister aux contraintes mécaniques sévères pendant le trajet, en particulier aux vibrations, secousses ou fortes variations de vitesse.

Une platine d'accueil avionique comporte un logement individuel pour chaque module et dispose, si besoin, de ventilation, et de connexions électriques. La platine d'accueil peut alors offrir aux modules un passage pour les flux d'air de ventilation en liaison avec leur environnement immédiat. L'invention peut également s'appliquer à des platines d'accueil utilisés dans d'autres domaines de transport où des contraintes similaires existent (automobile, ferroviaire, etc.).

Les platines avioniques d'accueil de modules amovibles ou LRU obéissent à la norme ARINC ou à d'autres standards Une platine équipée d'un moyen de verrouillage de module conforme à cette norme est par exemple décrite dans le document de brevet US 6 797 879. Dans ce moyen de verrouillage, un écrou muni d'une molette est fixé au bas du module au moyen d'une vis articulée. Pour maintenir ce module, la vis est insérée dans une fente agencée dans le rebord inférieur d'une platine d'accueil. L'écrou est ensuite serré. Cet écrou est équipé d'un dispositif à cliquet empêchant son desserrage intempestif sous les vibrations. Mais ce moyen de verrouillage présente plusieurs inconvénients: le réglage de la force de fixation est aléatoire, une force de serrage trop faible ne verrouille pas suffisamment le module et une force de serrage trop forte risque de dégrader le moyen de verrouillage; aucun moyen visuel de contrôle de l'état du verrouillage n'est prévu; une durée trop longue de l'opération de serrage, et l'utilisation de deux verrous indépendants nécessite une double gestion.

### ÉTAT DE LA TECHNIQUE

Plusieurs solutions ont contribué à améliorer ce système de verrouillage. Le document de brevet FR 2 938 022 présente par exemple un dispositif pouvant être inséré dans un support de réception et comportant deux poignées de verrouillage latérales maintenant le dispositif par des moyens de rappel élastique montés dans le support.

Chaque poignée est montée en rotation sur le dispositif et comporte une came excentrique ouverte. Une protubérance du support est introduite et circule dans chaque came ouverte lorsqu'une force de traction est exercée sur les poignées en rotation contre la force de rappel. Le verrouillage est réalisé lorsque la protubérance est en butée dans la came en équilibre avec la force de rappel.

Cependant, ces moyens ne verrouillent pas à proprement parler le dispositif dans le support mais constituent des moyens de positionnement du dispositif car l'équilibre réalisé avec les moyens de rappel n'est pas consolidé. De plus les moyens utilisés (constante de raideur variable dans le temps, cames ouvertes, poignées montées en rotation) ont une durée de vie limitée, sont relativement complexes et fragiles et comprennent deux systèmes à coordonner exactement.

Dans un autre document EP3 008 983, une poignée pivotante fixe un module d'interconnexion sur le côté d'un meuble électronique de réception, par l'exercice d'un double mouvement sur cette poignée: d'abord un mouvement latéral de mise en position transversale sur un côté du meuble, puis un mouvement de translation perpendiculaire au mouvement latéral pour l'insertion du module vers le côté du meuble. Un tel système présente une cinématique complexe de rotation-translation, avec un nombre important d'éléments (connecteurs de paroi arrière et de faces latérales, couplage de connecteurs à la paroi de fond, moyens de fermeture, moyens de verrouillage libérable, poignée de module, etc.), ce qui génère également une augmentation de masse.

Le document EP 1 331 712 décrit un appareil électrique comprenant une embase qui peut recevoir un organe constituant et qui peut se fixer sur un profilé porteur, notamment de type chapeau, au moyen d'un dispositif de verrouillage à deux crans opposés de fixation dont l'un est solidaire d'un coulisseau. Un organe manuel de déverrouillage du coulisseau comprend un levier monté pivotant autour d'au moins tourillon d'axe perpendiculaire à la direction de glissement du coulisseau, le tourillon étant situé près du fond de l'embase. Le levier coopère avec le coulisseau par un dispositif de came à glissière guidant un axe parallèle à l'axe du tourillon.

Le document US 5 010 426 décrit un mécanisme d'installation pour un lecteur d'ordinateur amovible.

### EXPOSÉ DE L'INVENTION

L'invention a pour objectif principal de permettre la fixation réversible de module dans une platine en apportant facilité et simplicité d'utilisation, ainsi que réduction des masses tout en garantissant une haute résistance aux vibrations, secousses, turbulences ou accélérations/décélérations. Pour ce faire, l'invention prévoit une manipulation de fermeture unique par rotation induisant un verrouillage par translation et un blocage réversible de chaque module, sans outil ni nécessité de réglage.

**A** cet effet, la présente invention a pour objet un procédé de verrouillage-déverrouillage d'un module amovible dans une platine d'accueil fixe comportant une paroi de support dudit module amovible. Le module amovible dispose de deux tenons pourvus chacun d'une lumière, ces tenons s'étendant hors du module amovible de sorte à pouvoir s'insérer dans des ouvertures formées dans la platine d'accueil. Ce procédé consiste, dans la phase de verrouillage, à :
- poser le module amovible sur la paroi de la platine d'accueil en insérant les deux tenons dans les ouvertures de la paroi de support de la platine d'accueil;
- activer un levier à cames excentriques vers une position de verrouillage, ce levier étant monté en rotation entre les ouvertures sous la paroi de support entre une position de déverrouillage et la position de verrouillage;
- entraîner par cette rotation deux pions en translations opposées, chaque pion coopérant avec une came excentrique tout en étant solidaire d'une extension s'étendant transversalement à la paroi de support de sorte que les extensions traversent perpendiculairement les lumières des tenons du module amovible, et
- bloquer le levier en position de verrouillage de manière réversible.

Et en phase de déverrouillage, à :
- débloquer le levier de sa position de verrouillage;
- activer la rotation inverse du levier jusqu'en en position de déverrouillage de sorte à entrainer le retrait des extensions hors des lumières via la translation inverse des pions, et
- sortir le module de la platine d'accueil.

Avantageusement, la position de verrouillage est signalée par un signal, en particulier un signal sonore ou lumineux. De plus, un contrôle visuel permet de vérifier cette position de verrouillage.

La présente invention a également pour objet un ensemble de verrouillage/déverrouillage formé d'un ou plusieurs modules amovibles et d'une platine d'accueil, l'ensemble étant équipé d'un système de verrouillage/déverrouillage de mise en œuvre d'un tel procédé. Dans cet ensemble, la platine d'accueil comporte une paroi de support de chaque module amovible, et chaque module amovible est pourvu de deux tenons traversés par une lumière, les tenons s'étendant hors du module amovible de sorte à pouvoir s'insérer dans des ouvertures formées dans la paroi de support.

De plus, le système de verrouillage/déverrouillage est muni d'un levier s'étendant sous la paroi de support et pourvu de deux chemins de came excentriques en arc de cercle agencées selon une symétrie axiale décalée formant une figure en « S » autour d'un axe de rotation central perpendiculaire à la paroi de support, le levier étant fixé en rotation sur cet axe central à même distance des deux ouvertures. Chaque came coopère avec un pion solidaire d'une extension mobile en translation par des moyens de guidage le long de la paroi de support à travers les lumières des tenons de chaque module amovible. Ainsi, le levier en rotation peut entraîner en translation opposée les deux pions solidaires et les extensions entre deux positions extrêmes de verrouillage / déverrouillage, la position de verrouillage étant de préférence bloquée par des moyens de fixation réversible en liaison avec la paroi de support.

Avantageusement, la position extrême de verrouillage est définie par une position de blocage donnée par les moyens de fixation réversible. Et la position extrême de déverrouillage est définie par une position des pions en butée dans les chemins de came.

Les avantages d'un tel ensemble sont de permettre de verrouiller chaque module en une seule manipulation, et d'exercer une force de serrage prédéfinie pour réaliser ce verrouillage. De plus, un tel ensemble apporte un positionnement fidèle et très précis, supérieur à celui obtenu par une fixation selon la norme ARINC. Un tel ensemble est donc bien adapté pour être utilisé dans un aéronef ou dans un environnement ayant de fortes contraintes mécaniques (secousses, vibrations, etc.).

Selon des caractéristiques avantageuses :
- la paroi de support s'étendant principalement selon une direction longitudinale, les ouvertures de la paroi de support se présentent de préférence selon des fentes parallèles à la direction longitudinale de ladite paroi;
- les moyens de fixation réversible sont choisis parmi des bandes auto-agrippantes, un bouton de verrouillage, un clips et un loquet quart de tour ;
- le module amovible possédant une paroi avant et une paroi arrière dressées en bordure d'une surface de contact venant après verrouillage contre la paroi de support de la platine d'accueil, les tenons sont agencés en prolongement de la paroi avant et la paroi arrière dispose d'au moins un logement d'engagement d'un taquet d'assemblage du module amovible à la platine d'accueil, ce taquet étant agencé sur une paroi dressée en bordure de la platine d'accueil ;
- la paroi arrière dispose également d'au moins un connecteur de couplage à un autre connecteur agencé sur la paroi dressée en bordure de la platine d'accueil, ces connecteurs pouvant être électriques, hydrauliques, optiques ou équivalents ;
- la surface de contact du module amovible et la paroi de support de la platine d'accueil disposant chacune d'une ouverture de ventilation agencées face à face, et l'une au moins de ces ouvertures étant bordée d'un joint d'étanchéité de ces ouvertures, le verrouillage du module amovible par le système de verrouillage / déverrouillage et l'assemblage par le ou les taquets écrasent le joint
d'étanchéité ; dans ces conditions, la précision du verrouillage permet de définir la position finale du module avec exactitude;
- le matériau du levier et des extensions est choisi parmi un composite, une matière plastique et un alliage métallique;
- les extensions sont effilées ;
- la position de verrouillage est communiquée par un signal.

L'invention a également pour objet un aéronef comportant au moins un ensemble de verrouillage/déverrouillage formé d'un ou plusieurs modules amovibles et d'une ou plusieurs platines d'accueil, tels que définis ci-dessus.

Dans le présent texte, les qualificatifs « sur », « dessous » et « sous » se rapportent aux localisations d'éléments par rapport aux équipements positionnés en utilisation standard. Sur les figures, des éléments identiques ou analogues sont repérés par un même signe de référence qui renvoie au(x) passage(s) de la description qui le mentionne(nt).

### PRÉSENTATION DES FIGURES

D'autres données, caractéristiques et avantages de la présente invention apparaîtront à la lecture de la description qui suit, en référence aux figures annexées qui représentent, respectivement :
- la figure 1, une vue partielle en perspective d'un exemple d'ensemble formé d'un module amovible, d'une platine d'accueil et d'un système de verrouillage/déverrouillage du module sur la platine selon l'invention;
- les figures 2a et 2b, deux premières étapes du procédé de verrouillage/déverrouillage selon l'invention du module sur la platine de l'exemple selon la figure 1;
- la figure 3, une vue du dessous du système de verrouillage / déverrouillage et de la platine d'accueil selon les figures précédentes;
- les figures 4a à 4c, trois phases de verrouillage du procédé selon l'invention, et
- les figures 5a à 5c, trois phases de déverrouillage du procédé selon l'invention.

### DESCRIPTION DÉTAILLÉE

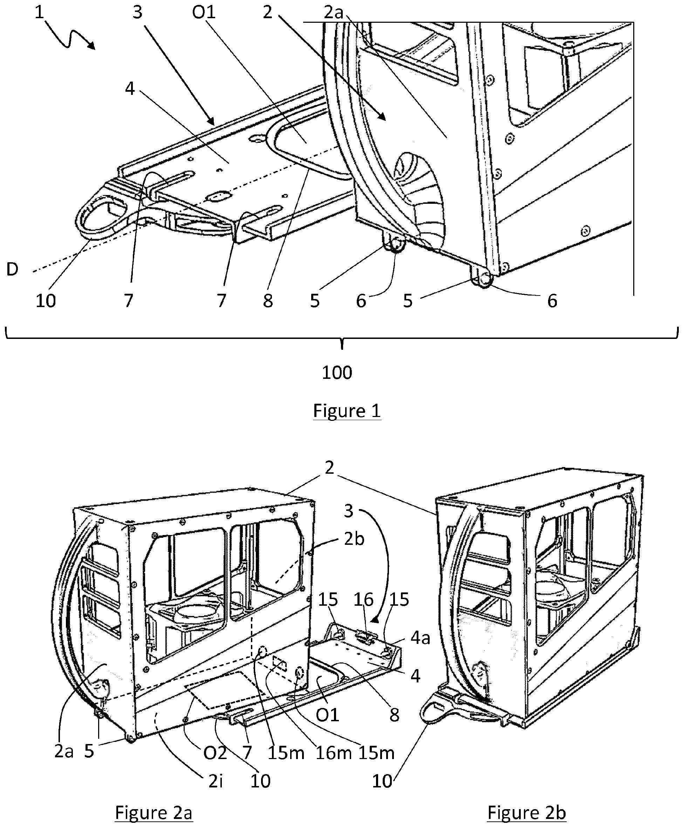

La figure 1 présente une vue perspective d'un exemple d'ensemble 1 selon l'invention formé d'un module amovible 2 de type module électronique ou autre module utilitaire pour l'équipage, d'une platine d'accueil 3 et d'un système de verrouillage/déverrouillage 100. Le module amovible 2 en forme sensiblement parallélépipédique comporte en particulier une surface de contact 2i et des parois avant 2a et arrière 2b dressées en bordure de la surface de contact 2i. Le module amovible 2 est pourvu de deux tenons 5 traversés par un alésage 6 formant une lumière, les tenons 5 prolongeant la paroi avant 2a du module 2 hors de ce module amovible. La platine d'accueil 3 comporte une paroi de support 4 du module amovible 2.

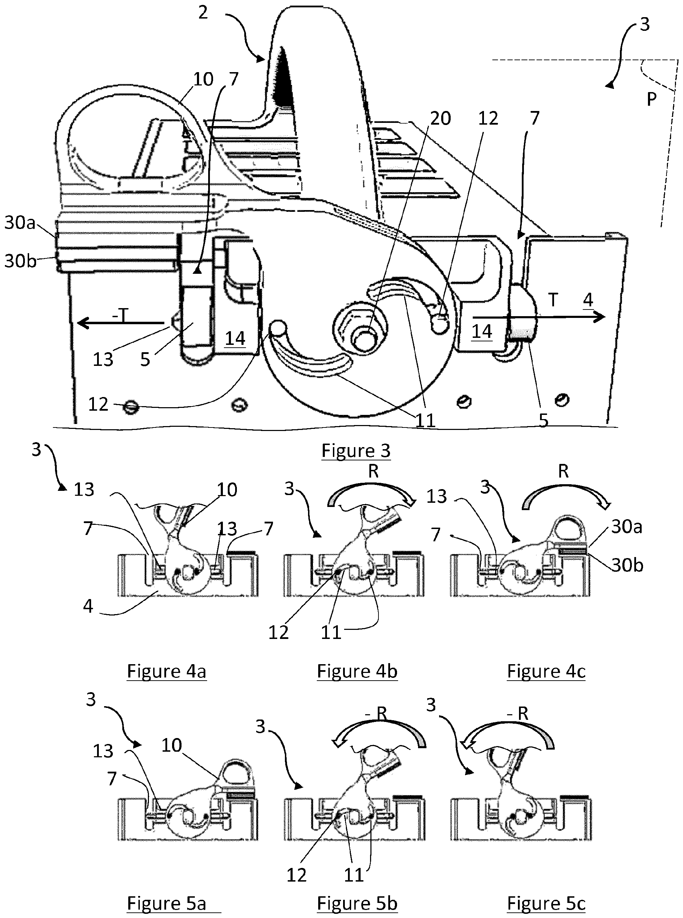

Ces tenons 5 s'insèrent dans des fentes parallèles 7 formées dans la paroi de support 4. De plus, le système de verrouillage/déverrouillage 100 comporte un levier 10 s'étendant sous la paroi de support 4, transversalement à cette paroi 4 globalement rectangulaire, c'est-à-dire perpendiculairement à sa direction principale « D ». Le fonctionnement du levier 10 est détaillé en référence à la figure 3.

Les figures 2a et 2b présentent deux premières étapes du procédé de verrouillage / déverrouillage selon l'invention. Sur la figure 2a, le module amovible 2 est en cours de pose sur la platine d'accueil 3, le levier 10 (qui est masqué par le module amovible 2 sur cette figure), est en position de déverrouillage. Les tenons 5 agencés sous le module 2 sont destinés à s'insérer dans les fentes 7 formées dans la paroi de support 4, la figure 2b illustrant le positionnement du module 2 après insertion des tenons 5 dans les fentes 7. Sur cette figure 2b, le module amovible 2 est posé sur la platine d'accueil 3, le levier 10 étant désormais en position de verrouillage.

Le module amovible 2 possède une paroi avant 2a et une paroi arrière 2b, ces deux parois étant dressées en bordure d'une surface de contact 2i, cette surface de contact 2i faisant face à la paroi de support 4 de la platine d'accueil 3, après verrouillage du module 2 sur la platine 3. La paroi arrière 2b du module 2 dispose de deux logements 15m pouvant accepter chacun un taquet 15 d'assemblage agencé sur la paroi arrière 4a de la platine d'accueil 3. De plus, la paroi arrière 2a du module 2 dispose également d'un connecteur électrique 16m apte à se connecter avec un autre connecteur électrique 16 agencé sur la paroi arrière 4a de la platine d'accueil 3.

La surface de contact 2i du module 2 présente une ouverture de ventilation O2, qui se place en face d'une ouverture O1 agencée sur la paroi de support 4 de la platine d'accueil 3, après le verrouillage du module 2. L'ouverture O1 est bordée d'un joint d'étanchéité 8. Le verrouillage du module 2 par le système de verrouillage / déverrouillage et l'assemblage par les taquets 15 permet d'écraser le joint d'étanchéité 8 avec assez de force pour assurer une bonne étanchéité.

La figure 3 montre plus précisément le fonctionnement du levier 10, vu du dessous de la platine d'accueil 3, lorsque cette platine supporte le module 2. Ce levier 10 s'étend sous la paroi de support 4, et est pourvu de deux chemins de cames excentriques 11 circulaires agencés en symétrie axiale décalée, formant un « S » autour d'un axe de rotation central 20 perpendiculaire à la paroi de support 4. Le levier 10 est fixé en rotation sur cet axe central 20 à même distance des deux fentes 7.

Chaque came 11 coopère avec un pion 12 solidaire d'une extension transversale cylindrique 13 (perpendiculaire à la direction longitudinale de la paroi 4). Ces extensions 13 sont mobiles en translation opposée (flèches « T » et « --T ») dans des alésages (non visibles sur la figure) formés dans des bossages14 solidaires de la paroi de support 4. Alternativement, les extensions transversales 13 peuvent être guidées par une rainure, ou des pontets.

Le levier 10 mis en rotation par l'opérateur entraîne alors les pions 12 entre deux positions extrêmes de verrouillage / déverrouillage. Le levier 10 entraîne alors simultanément les extensions 13 en translation opposée « T » et « -T » à travers les alésages 6 (cf. figure 1) des tenons 5. Avantageusement, les extensions 13 présentent des extrémités effilées pour avancer aisément dans les alésages au sein des bossages 14.

Ainsi, la mise en position de verrouillage du levier 10 permet de maintenir le module amovible 2 par une manipulation de fermeture unique par rotation induisant un verrouillage par translation et un blocage réversible, sans outil ni nécessité de réglage.

Le blocage de la position de verrouillage, dans cet exemple de réalisation, est effectué par des bandes auto-agrippantes 30a et 30b, la bande 30a étant solidaire du levier 10, et la bande 30b étant solidaire de la paroi de support 4. Alternativement, le blocage réversible peut être réalisé par un bouton de verrouillage, un clips et un loquet quart de tour. En outre, le levier 10 et les extensions 13 sont constitués dans l'exemple par des alliages métalliques. Dans d'autres exemples de réalisation ces pièces sont en matière plastique ou en matériau composite.

Les vues des figures 4a à 4c, et 5a à 5c qui illustrent les phases de verrouillage et de déverrouillage sont réalisées dans un plan « P » de la figure 3, parallèle à la paroi de support 4.

Les figures 4a à 4c présentent trois phases principales de verrouillage du procédé selon l'invention. Sur la figure 4a, le levier 10 est en position de déverrouillage, les deux extensions 13 sont rétractées du côté du levier 10 et les deux fentes 7 sont donc libres d'accès. Une fois le module 2 posé et ses tenons 5 (cf. figure 3) insérées dans les fentes 7, le levier à cames excentriques 10 est activé en rotation « R» vers une position de verrouillage, comme illustré par la figure 4b.

Cette activation entraîne les pions 12 en translations opposées, chaque pion 12 coopérant avec une came excentrique 11 tout en étant solidaire d'une extension 13 s'étendant parallèlement au plan P. Les extensions 13 traversent alors les alésages 6 des tenons 5 (cf. figure 1). Sur la figure 4c, le blocage du levier 10 en position de verrouillage est réalisé de manière réversible, au moyen des bandes auto-agrippantes 30a et 30b.

La position de verrouillage est avantageusement signalée par une alerte sonore et/ou visuelle, suite au contact des extensions 13 avec la paroi des fentes 7, ou par le contact du levier 10 en position de verrouillage sur un contact placé à proximité de la bande auto-agrippante 30b.

Les figures 5a à 5c présentent trois phases principales du procédé de déverrouillage selon l'invention. Sur la figure 5a, le levier 10 est placé dans sa position de verrouillage. Puis, sur la figure 5b, la rotation inverse « -R » du levier 10 est activée jusqu'en en position de déverrouillage, ce qui entraîne le retrait des extensions 13 via la translation inverse des pions 12. Enfin, en figure 5c, après le retrait des extensions 13, le module 2 (cf. figures 1, 2 ou 3) peut être sorti de la platine d'accueil.

L'invention n'est pas limitée aux exemples de réalisation décrits et représentés. Ainsi, les fentes peuvent être parallèles entre elles, ou non parallèles, il suffit que la position des fentes de la platine d'accueil soit compatible avec la position des tenons. En outre, les fentes peuvent être remplacées par des orifices circulaires. Par ailleurs, le module amovible et la platine d'accueil peuvent comporter d'ouvertures destinées à l'allégement du poids de ces pièces. De plus, les connecteurs à l'arrière peuvent être de type électrique, hydraulique, optique ou équivalents.

## Revendications

1. Procédé de verrouillage-déverrouillage d'un module amovible (2) dans une platine d'accueil fixe (3) comportant une paroi de support (4) dudit module amovible (2) disposant de deux tenons (5) pourvus chacun d'une lumière (6), ces tenons (5) s'étendant hors du module amovible (2) de sorte à pouvoir s'insérer dans des ouvertures (7) formées dans la platine d'accueil (3), ce procédé consistant, dans la phase de verrouillage, à :
- poser le module amovible (2) sur la paroi (4) de la platine d'accueil (3) en insérant les deux tenons (5) dans les ouvertures (7) de la paroi de support (4) de la platine d'accueil (3);
- activer un levier (10) à cames excentriques (11) vers une position de verrouillage, ce levier (10) étant monté en rotation entre les ouvertures sous la paroi de support (4) entre une position de déverrouillage et la position de verrouillage;
- entraîner par cette rotation deux pions (12) en translations opposées, chaque pion (12) coopérant avec une came excentrique (11) tout en étant solidaire d'une extension (13) s'étendant transversalement à la paroi de support (4) de sorte que les extensions (13) traversent perpendiculairement les lumières (6) des tenons (5) du module amovible (2), et
- bloquer le levier (10) en position de verrouillage de manière réversible ; et, dans la phase de déverrouillage, à :
- débloquer le levier (10) de sa position de verrouillage;
- activer la rotation inverse du levier (10) jusqu'en en position de déverrouillage de sorte à entrainer le retrait des extensions (13) hors des lumières (6) via la translation inverse des pions (12), et
- sortir le module (2) de la platine d'accueil (3).

2. Procédé de verrouillage-déverrouillage selon la revendication 1, dans lequel la position de verrouillage est communiquée par un signal.

3. Ensemble de verrouillage/déverrouillage formé d'un ou plusieurs modules amovibles (2) et d'une platine d'accueil (3) de mise en œuvre du procédé selon l'une ou l'autre des revendications précédentes, comportant une paroi de support (4) de chaque module amovible (2), chaque module amovible (2) étant pourvu de deux tenons (5) traversés par une lumière (6), les tenons (5) s'étendant hors du module amovible (2) de sorte à pouvoir s'insérer dans des ouvertures (7) formées dans la paroi de support (4), et en ce qu'il est muni d'un système de verrouillage/déverrouillage (100) comportant un levier (10) s'étendant sous la paroi de support (4) et pourvu de deux chemins de came excentriques en arc de cercle (11) agencées selon une symétrie axiale décalée formant une figure en « S » autour d'un axe de rotation central (20) perpendiculaire à la paroi de support (4), le levier (10) étant fixé en rotation sur cet axe central (20) à même distance des deux ouvertures (7), et chaque came (11) coopérant avec un pion (12) solidaire d'une extension (13) mobile en translation par des moyens de guidage le long de la paroi de support (4) à travers les lumières (6) des tenons (5) de chaque module amovible (2).

4. Ensemble de verrouillage/déverrouillage selon la revendication précédente, dans lequel le levier (10) en rotation est apte à entraîner en translation opposée les deux pions (12) solidaires et les extensions (13) entre deux positions extrêmes de verrouillage / déverrouillage, la position de verrouillage étant bloquée par des moyens de fixation réversible (30a, 30b) en liaison avec la paroi de support (4).

5. Ensemble de verrouillage/déverrouillage selon l'une quelconque des revendications 3 ou 4, dans lequel la paroi de support (4) s'étendant principalement selon une direction longitudinale, les ouvertures (7) de la paroi de support (4) se présentent selon des fentes (7) parallèles à la direction longitudinale de ladite paroi (4).

6. Ensemble de verrouillage/déverrouillage selon l'une quelconque des revendications 3 à 5, dans lequel les moyens de fixation réversible sont choisis parmi des bandes auto-agrippantes (30a, 30b), un bouton de verrouillage, un clips et un loquet quart de tour.

7. Ensemble de verrouillage/déverrouillage selon l'une quelconque des revendications 3 à 6 dans lequel, le module amovible (2) possédant une paroi avant (2a) et une paroi arrière (2b) dressées en bordure d'une surface de contact (2i) venant après verrouillage contre la paroi de support (4) de la platine d'accueil (3), les tenons (5) sont agencés en prolongement de la paroi avant (2a) et la paroi arrière (2b) dispose d'au moins un logement (15m) d'engagement d'un taquet d'assemblage (15) du module amovible (2) à la platine d'accueil (3), ce taquet (15) étant agencé sur une paroi (4a) dressée en bordure de la platine d'accueil (3).

8. Ensemble de verrouillage/déverrouillage selon la revendication 7 dans lequel la paroi arrière (2b) dispose également d'au moins un connecteur (16m) de couplage à un autre connecteur (16) agencé sur la paroi (4a) dressée en bordure de la platine d'accueil (3).

9. Ensemble de verrouillage/déverrouillage selon l'une quelconque des revendications 7 ou 8 dans lequel, la surface de contact (2i) du module amovible (2) et la paroi de support (4) de la platine d'accueil (3) disposant chacune d'une ouverture de ventilation (O1, O2) agencées face à face, et l'une au moins de ces ouvertures étant bordée d'un joint d'étanchéité (8) de ces ouvertures (O1, O2), le verrouillage du module amovible (2) par le système de verrouillage / déverrouillage et l'assemblage par le ou les taquets (15) écrasent le joint d'étanchéité (8).

10. Ensemble de verrouillage/déverrouillage selon l'une quelconque des revendications 4 à 9 dans lequel le matériau du levier (10) et des extensions (13) est choisi parmi un composite, une matière plastique et un alliage métallique.

11. Ensemble de verrouillage/déverrouillage selon l'une quelconque des revendications 4 à 10 dans lequel les extensions (13) sont effilées.

12. Aéronef **caractérisé en ce que** qu'il comporte au moins un ensemble de verrouillage/déverrouillage formé d'un ou plusieurs modules amovibles (2) et d'une ou plusieurs platines d'accueil correspondantes (3) selon l'une quelconque des revendications 3 à 11.

## Patentansprüche

1. Verfahren zum Verriegeln/Entriegeln eines abnehmbaren Moduls (2) in einer eine Stützwand (4) für das abnehmbare Modul (2) aufweisenden, ortsfesten aufnehmenden Platine (3), das über zwei Zapfen (5) verfügt, die jeweils mit einem Schlitz (6) versehen sind, wobei sich diese Zapfen (5) aus dem abnehmbaren Modul (2) hinaus erstrecken, um in Öffnungen (7) eingesetzt werden zu können, die in der aufnehmenden Platine (3) ausgebildet sind, wobei dieses Verfahren in der Verriegelungsphase darin besteht:
- das abnehmbare Modul (2) auf die Wand (4) der aufnehmenden Platine (3) zu setzen und dabei die zwei Zapfen (5) in die Öffnungen (7) der Stützwand (4) der aufnehmenden Platine (3) einzusetzen;
- einen Hebel (10) mit Exzenternocken (11) in Richtung einer Verriegelungsposition zu betätigen, wobei dieser Hebel (10) zwischen den Öffnungen unter der Stützwand (4) zwischen einer Entriegelungsposition und der Verriegelungsposition drehbar gelagert ist;
- durch diese Drehung zwei Stifte (12) in entgegengesetzten Richtungen translatorisch zu bewegen, wobei jeder Stift (12) mit einem Exzenternocken (11) zusammenwirkt und dabei mit einem Ansatz (13) fest verbunden ist, der sich quer zu der Stützwand (4) erstreckt, derart, dass die Ansätze (13) die Schlitze (6) der Zapfen (5) des abnehmbaren Moduls (2) orthogonal durchqueren, und
- den Hebel (10) in der Verriegelungsposition reversibel zu blockieren;
und in der Verriegelungsphase:
- den Hebel (10) aus seiner Verriegelungsposition zu lösen;
- die umgekehrte Drehung des Hebels (10) bis in die Entriegelungsposition durchzuführen, um durch den umgekehrte Translation der Stifte (12) das Zurückziehen der Ansätze (13) aus den Schlitzen (6) zu bewirken, und
- das Modul (2) aus der aufnehmenden Platine (3) zu entnehmen.

2. Verfahren zum Verriegeln/Entriegeln nach Anspruch 1, wobei die Verriegelungsposition durch ein Signal übermittelt wird.

3. Anordnung zum Verriegeln/Entriegeln, die von einem oder mehreren abnehmbaren Modulen (2) und einer aufnehmenden Platine (3) zur Implementierung des Verfahrens nach einem der vorhergehenden Ansprüche gebildet wird,
welche eine Stützwand (4) für jedes abnehmbare Modul (2) aufweist, wobei jedes abnehmbare Modul (2) mit zwei Zapfen (5) versehen ist, die von einem Schlitz (6) durchquert werden, wobei sich die Zapfen (5) aus dem abnehmbaren Modul (2) hinaus erstrecken, um in Öffnungen (7) eingesetzt werden zu können, die in der Stützwand (4) ausgebildet sind, und dadurch, dass sie mit einem System zum Verriegeln/Entriegeln (100) ausgestattet ist, das einen Hebel (10) aufweist, der sich unter der Stützwand (4) erstreckt und mit zwei kreisbogenförmigen exzentrischen Nockenbahnen (11) versehen ist, die mit einer versetzten axialen Symmetrie angeordnet sind und eine S-förmige Figur um eine zentrale Drehachse (20) bilden, die zu der Stützwand (4) senkrecht ist, wobei der Hebel (10) drehbar auf dieser zentralen Achse (20) in gleichem Abstand von den zwei Öffnungen (7) befestigt ist, und wobei jeder Nocken (11) mit einem Stift (12) zusammenwirkt, der mit einem Ansatz (13) fest verbunden ist, der durch Führungsmittel entlang der Stützwand (4) durch die Schlitze (6) der Zapfen (5) jedes abnehmbaren Moduls (2) hindurch translatorisch bewegbar ist.

4. Anordnung zum Verriegeln/Entriegeln nach dem vorhergehenden Anspruch, wobei der Hebel (10), wenn er eine Drehung ausführt, in der Lage ist, die zwei fest verbundenen Stifte (12) und Ansätze (13) zwischen zwei äußersten Positionen der Verriegelung bzw. Entriegelung in entgegengesetzten Richtungen translatorisch zu bewegen, wobei die Verriegelungsposition durch Mittel zur reversiblen Befestigung (30a, 30b), die mit der Stützwand (4) in Verbindung stehen, arretiert wird.

5. Anordnung zum Verriegeln/Entriegeln nach einem der Ansprüche 3 oder 4, wobei, wenn sich die Stützwand (4) hauptsächlich in einer Längsrichtung erstreckt, die Öffnungen (7) der Stützwand (4) die Form von Spalten (7) aufweisen, die zur Längsrichtung der Wand (4) parallel sind.

6. Anordnung zum Verriegeln/Entriegeln nach einem der Ansprüche 3 bis 5, wobei die Mittel zur reversiblen Befestigung aus Klettbändern (30a, 30b), einem Verriegelungsknopf, einem Klips und einem Vorreiberverschluss ausgewählt sind

7. Anordnung zum Verriegeln/Entriegeln nach einem der Ansprüche 3 bis 6, wobei, wenn das abnehmbare Modul (2) eine vordere Wand (2a) und eine hintere Wand (2b) besitzt, die am Rand einer Kontaktfläche (2i) hochstehen, die nach einer Verriegelung an der Stützwand (4) der aufnehmenden Platine (3) zur Anlage kommt, die Zapfen (5) in Verlängerung der vorderen Wand (2a) angeordnet sind und die hintere Wand (2b) über wenigstens eine Aufnahme (15m) zum Eingriff einer Nase (15) zum Zusammenbau des abnehmbaren Moduls (2) mit der aufnehmenden Platine (3) verfügt, wobei diese Nase (15) an einer Wand (4a) angeordnet ist, die am Rand der aufnehmenden Platine (3) hochsteht.

8. Anordnung zum Verriegeln/Entriegeln nach Anspruch 7, wobei die hintere Wand (2b) außerdem über wenigstens einen Verbinder (16m) zur Kopplung mit einem anderen Verbinder (16) verfügt, der an der Wand (4a) angeordnet ist, die am Rand der aufnehmenden Platine (3) hochsteht.

9. Anordnung zum Verriegeln/Entriegeln nach einem der Ansprüche 7 oder 8, wobei die Kontaktfläche (2i) des abnehmbaren Moduls (2) und die Stützwand (4) der aufnehmenden Platine (3) jeweils über eine Belüftungsöffnung (O1, O2) verfügen, wobei diese Öffnungen einander gegenüber angeordnet sind und wenigstens eine von ihnen von einer Dichtung (8) für diese Öffnungen (O1, O2) umrandet wird, wobei die Verriegelung des abnehmbaren Moduls (2) durch das System zum Verriegeln/Entriegeln und der Zusammenbau durch die Nase oder die Nasen (15) ein Zusammenquetschen der Dichtung (8) bewirken.

10. Anordnung zum Verriegeln/Entriegeln nach einem der Ansprüche 4 bis 9, wobei das Material des Hebels (10) und der Ansätze (13) aus einem Verbundwerkstoff, einem Kunststoff und einer Metalllegierung ausgewählt ist.

11. Anordnung zum Verriegeln/Entriegeln nach einem der Ansprüche 4 bis 10, wobei die Ansätze (13) konisch zulaufend sind.

12. Luftfahrzeug, **dadurch gekennzeichnet, dass** es wenigstens eine Anordnung zum Verriegeln/Entriegeln, die von einem oder mehreren abnehmbaren Modulen (2) und einer oder mehreren entsprechenden aufnehmenden Platinen (3) gebildet wird, nach einem der Ansprüche 3 bis 11 aufweist.

## Claims

1. A method for locking/unlocking a removable module (2) in/from a fixed mounting plate (3) having a wall (4) for supporting said removable module (2) that has two tenons (5) each provided with a hole (6), these tenons (5) extending out from the removable module (2) so that they can be inserted into openings (7) formed in the mounting plate (3), this method consisting, in the locking phase, in:
- placing the removable module (2) on the wall (4) of the mounting plate (3), inserting the two tenons (5) into the openings (7) in the support wall (4) of the mounting plate (3);
- activating a lever (10) with eccentric cams (11) toward a locked position, this lever (10) being mounted in rotation between the openings beneath the support wall (4) between an unlocked position and the locked position;
- driving, by this rotation, two pins (12) in opposite translational movements, each pin (12) cooperating with an eccentric cam (11) while being secured to an extension (13) that extends transversely to the support wall (4) such that the extensions (13) pass through the holes (6) in the tenons (5) of the removable module (2) perpendicularly, and
- reversibly blocking the lever (10) in the locked position; and, in the unlocking phase, in:
- unblocking the lever (10) from its locked position;
- activating the reverse rotation of the lever (10) until it is in the unlocked position so as to cause the extensions (13) to be withdrawn from the holes (6) via the reverse translation of the pins (12), and
- removing the module (2) from the mounting plate (3).

2. The locking/unlocking method as claimed in claim 1, wherein the locked position is communicated by a signal.

3. A locking/unlocking assembly formed from one or more removable modules (2) and from a mounting plate (3) for implementing the method as claimed in one or other of the preceding claims, consisting it has a wall (4) for supporting each removable module (2), each removable module (2) being provided with two tenons (5) with a hole (6) passing through them, the tenons (5) extending out from the removable module (2) so that they can be inserted into openings (7) formed in the support wall (4), and in that it is provided with a locking/unlocking system (100) that has a lever (10) extending beneath the support wall (4) and provided with two camways of circular-arc eccentric cams (11) arranged with an offset axial symmetry, forming an "S" shape about a central rotary shaft (20) perpendicular to the support wall (4), the lever (10) being rotationally fixed to this central shaft (20) at the same distance from the two openings (7), and each cam (11) cooperating with a pin (12) secured to an extension (13) that is able to move in translation via guide means along the support wall (4) through the holes (6) in the tenons (5) of each removable module (2).

4. The locking/unlocking assembly as claimed in the preceding claim, wherein the lever (10), in rotating, is able to drive the two secured pins (12) and the extensions (13) in opposite translational movements between two extreme locked/unlocked positions, the locked position being blocked by reversible fastening means (30a, 30b) in connection with the support wall (4).

5. The locking/unlocking assembly as claimed in either one of claims 3 and 4, wherein, the support wall (4) extending primarily in a longitudinal direction, the openings (7) in the support wall (4) are in the form of slots (7) parallel to the longitudinal direction of said wall (4).

6. The locking/unlocking assembly as claimed in any one of claims 3 to 5, wherein the reversible fastening means are chosen from hook-and-loop fastener strips (30a, 30b), a locking button, a clip and a quarter-turn latch.

7. The locking/unlocking assembly as claimed in any one of claims 3 to 6, wherein, the removable module (2) having a front wall (2a) and a rear wall (2b) that are upright at the edge of a contact surface (2i) that comes after locking against the support wall (4) of the mounting plate (3), the tenons (5) are arranged in the extension of the front wall (2a) and the rear wall (2b) has at least one housing (15m) for engagement of a cleat (15) for assembling the removable module (2) with the mounting plate (3), this cleat (15) being arranged on an upright wall (4a) at the edge of the mounting plate (3).

8. The locking/unlocking assembly as claimed in claim 7, wherein the rear wall (2b) also has at least one connector (16m) for coupling with another connector (16) arranged on the upright wall (4a) at the edge of the mounting plate (3).

9. The locking/unlocking assembly as claimed in either one of claims 7 and 8, wherein, the contact surface (2i) of the removable module (2) and the support wall (4) of the mounting plate (3) each having a ventilation opening (O1, 02), which openings are arranged facing one another, and at least one of these openings being bordered by a seal (8) for these openings (O1, O2), the locking of the removable module (2) by the locking/unlocking system and the assembly by the one or more cleats (15) compress the seal (8).

10. The locking/unlocking assembly as claimed in any one of claims 4 to 9, wherein the material of the lever (10) and of the extensions (13) is chosen from a composite, a plastics material and a metal alloy.

11. The locking/unlocking assembly as claimed in any one of claims 4 to 10, wherein the extensions (13) are tapered.

12. An aircraft, **characterized in that** it has at least one locking/unlocking assembly formed from one or more removable modules (2) and from one or more corresponding mounting plates (3) as claimed in any one of claims 3 to 11.
